# EUROPEAN PATENT SPECIFICATION

(11) **EP 1 858 061 B1**
(45) Date of publication and mention of the grant of the patent: **19.10.2011**
(21) Application number: 06714438.6
(22) Date of filing: 23.02.2006
(51) Int. Cl.: H01L 21/205, H01L 21/3065

(54) **PLASMA TREATMENT APPARATUS AND SEMICONDUCTOR THIN FILM MANUFACTURING METHOD USING SAME**
PLASMABEHANDLUNGSVORRICHTUNG UND HALBLEITER-DÜNNFILM-HERSTELLUNGSVERFAHREN DAMIT
APPAREIL DE TRAITEMENT AU PLASMA ET PROCÉDÉ DE FABRICATION DE FILM MINCE SEMI-CONDUCTEUR UTILISANT LEDIT APPAREIL

(30) Priority: 07.03.2005 JP 2005062701
(43) Date of publication of application: 21.11.2007
(73) Proprietor: Sharp Kabushiki Kaisha, Osaka-shi, Osaka 545-8522 (JP)
(72) Inventor: KISHIMOTO, Katsushi, Souraku-gun, Kyoto 619-0232 (JP); FUKUOKA, Yusuke, Ikoma-gun, Nara 636-0116 (JP)
(74) Representative: Müller - Hoffmann & Partner
(86) International application number: PCT/JP2006/303298
(87) International publication number: WO 2006/095575

(56) References cited:
- WO-A1-02/068710
- JP-A- 05 326 450
- JP-A- 08 031 755
- JP-A- 09 129 561
- JP-A- 2000 306 844
- US-A- 4 264 393
- US-A- 5 383 984
- US-A1- 2004 069 230

## Description

### TECHNICAL FIELD

The present invention relates to a plasma processing apparatus that performs etching or film-forming on a substrate by plasma discharge of a reactive gas as well as a method of producing a semiconductor thin film using the same.

### BACKGROUND ART

Plasma processing apparatus are often used in producing a semiconductor element, and those having various forms are adapted for practical use in accordance with an object thereof.

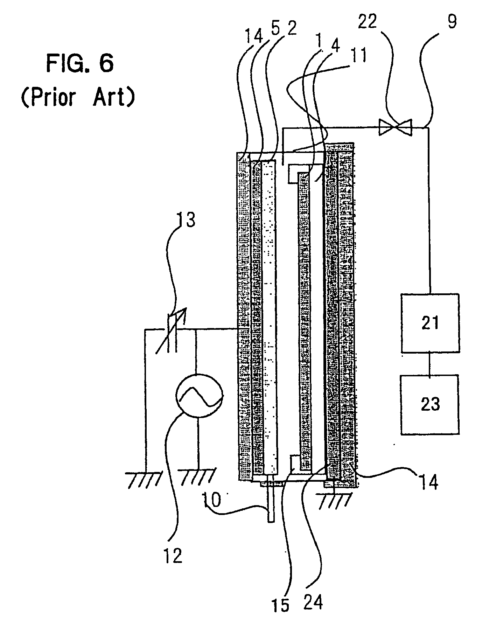

Fig. 6 is a schematic cross-sectional view of a conventional general longitudinal-type plasma processing apparatus.

This plasma processing apparatus includes a chamber 11 that becomes a reaction vessel by receiving influence of outside atmospheric pressure. On the inner wall surface of the chamber 11, a cathode 2 and an anode 4 that are opposing to each other for causing plasma discharge, and a heater 24 that heats a substrate 1 (for example, a glass substrate) serving as an object of processing are disposed. Here, the heater 24 is used also as a structural body that constitutes the wall surface of the chamber 11.

The cathode 2 is supported by the inner wall surface of the chamber 11 via a cathode support 5 made of an insulating substance in order to obtain electric insulation.
Also, the cathode 2 has a hollow section within the inside for introducing a reactive gas, and has numerous fine through-holes formed by a drilling process on the surface that opposes the substrate 1. Also, a gas introducing pipe 10 is connected to the end part of the cathode 2, whereby the reactive gas supplied into the cathode 2 passes through the hollow section and the through-holes to be supplied uniformly to the surface of the substrate 1.
Further, a plasma excitation power source 12 as a high-frequency power source for supplying high-frequency electric power to the cathode 2 and an impedance matching device 13 are connected to the cathode 2.

The anode 4 is fixed to the surface of the heater 24 that constitutes the inner wall surface of the chamber 11. Also, a substrate holding section (holder) 15 that holds the peripheral part of the substrate 1 is disposed on the other surface of the anode 4.
In order to form a film provided with uniform film thickness and film quality on the surface of the substrate 1, the gap distance between the cathode 2 and the anode 4 (plasma discharge region) must be set at a high precision. For this reason, the peripheral part of the cathode 2 is fixed at a constant interval by fixing screws (not illustrated in the drawings).
The chamber 11, the cathode 2, and the anode 4 are constituted with stainless steel, aluminum alloy, or the like and, as a heat-insulating material thereof, ceramics and the like are used. When an etching gas is used as the reactive gas, the whole chamber is constituted with aluminum alloy.

The substrate 1 serving as an object of processing is fixed to the substrate holding section 15, and is heated to a constant temperature (for example, 100°C to 600°C) by the heater 24.
In order to maintain the vacuum within the chamber, a vacuum sealing section (not illustrated in the drawings) is disposed at each connection part within the chamber. A fluorine-based rubber sealing material such as Viton (registered trademark) or Kalrez (registered trademark) manufactured by Dupont Dow Elastomer Co., Ltd. is used for the vacuum sealing section of the cathode 2 and the vacuum sealing section of the heater 24 that are affected by the reactive radical.

A cooling section 14 is disposed on the outside of the heater 24 and the cathode support 5 in order to restrain temperature rise of the chamber and the vacuum sealing sections.
In order to control the pressure of the reactive gas within the chamber freely, a gas exhausting outlet is disposed at one wall part near the plasma discharge region in the chamber, and a pressure controller 22, a vacuum pump 21, and a removing apparatus 23 for removing harmful substances within the exhaust gas are connected to this gas exhausting outlet via a gas exhausting pipe 9.

In such a plasma processing apparatus, a glow discharge is generated between the cathode 2 and the anode 4 in a state in which the pressure of the reactive gas is controlled, so as to form an amorphous or crystalline film on the substrate 1.
Also, in a plasma chemistry technique, a plasma reaction apparatus is proposed in which the uniformity of etching or film-forming is improved.

A conventional plasma processing apparatus such as described above has several problems such as the following.
(A) Since the cathode, the anode, and the heater are fixed to the upper wall and the bottom wall of the chamber, the heat conductance to the outside will be large, thereby necessitating grounding and a cooling apparatus (cooling section) for cooling the sealing sections.
(B) The cathode and the anode themselves require a high insulation against the chamber. However, since the cathode and the anode are used also as the wall surface of the chamber that is affected by the outside atmospheric pressure, the apparatus as a whole will be a large structural body, so that each constituent member will be expensive, and a cooling apparatus (cooling section) for cooling from the rear surface side of the chamber will be needed.
(C) Since the heater is fixed to the upper wall and the bottom wall of the chamber, the cooling of the fixing sections thereof will be needed.
(D) The cathode and the anode have a structure of being supported by the inner wall surface of the chamber via a structural body made of an insulating substance. Therefore, in introducing electric power, it is difficult to ensure a grounding distance to the wall surface, so that the plasma discharge also is liable to be affected by the wall surface and others. In order to restrain this influence to the minimum, the chamber wall surface must be spaced apart to the utmost extent from the cathode. If this is carried out, the size of the chamber will have a large scale, thereby giving a factor for great increase in the costs.
(E) Regarding the cathode which will be a large-scale structural body among the constituent members of the apparatus, electric insulation must be ensured against the chamber wall surface, and also leakage of the reactive gas must be prevented. For this reason, a large-scale insulating member will be needed, thereby giving a factor for great increase in the costs.
(F) When a fluorine-based etching gas is used as the reactive gas, an expensive fluorine-based rubber sealing material must be used for the vacuum sealing section of the cathode and the vacuum sealing sections of the anode near the plasma discharge region, thereby giving a factor for great increase in the costs.
(G) Since the gas exhausting outlet is disposed in one direction around the plasma discharge region, the conductance of the reactive gas will be small, making it difficult to perform exchange of a large amount of gas.
(H) Since the supply of high-frequency electric power is carried out from the rear surface side of the cathode, the plasma discharge region will be limited to one surface of the cathode on the front surface side.
(I) In the case of a longitudinal-type plasma processing apparatus, the substrate is fixed in the surroundings, thereby raising a fear of insufficient grounding.

In a plasma processing apparatus described in US 4,264,393, the anode and the cathode are arranged without being in contact with the surrounding members, so that a particular cooling mechanism is not provided.
This apparatus has an advantage in that the apparatus structure itself can be simplified, because there is no cooling mechanism such as in a conventional semiconductor processing apparatus.

However, this apparatus is not provided with a mechanism that can fully alleviate the heat generation by the plasma that is generated in film forming or cleaning (etching), thereby raising a fear of inviting a large obstacle against the stability of the process. Namely, when plasma is generated by supplying high-frequency electric power (RF) or direct current electric power (DC) to the plasma processing apparatus, partly a Joule heat of 418.68 to 4.186.8 J/min. (100 to 1000 cal/min) is generated, though most of the electric power is used for decomposition of the gas. This Joule heat raises the substrate temperature at 0.1 to 1°C / min. For example, in the case in which the processing time accompanied by plasma discharge is 20 minutes, a substrate temperature rise of up to 20°C will be invited. The inventors of the present invention have confirmed a fact of such temperature rise by an experiment.

### DISCLOSURE OF THE INVENTION

### PROBLEMS TO BE SOLVED BY THE INVENTION

An object of the present invention is to provide a plasma processing apparatus that can arrange a cathode and an anode with a simple structure and that can obtain a good film deposition and film thickness distribution, leading to simplification of the whole structure of the apparatus and thereby further realizing the lowering of costs, as well as a method of producing a semiconductor thin film using the same.

### MEANS FOR SOLVING THE PROBLEMS

Thus, the present invention provides a plasma processing apparatus as specified in claim 1. and that heats the substrate within the inside space; and
heat-dissipating means capable of dissipating a Joule heat generated by the plasma discharge to outside of the inside space.

Also, the present invention provides a method of producing a semiconductor thin film characterized by producing a semiconductor thin film on a surface of a substrate by using the plasma processing apparatus described above.

Preferred embodiments of the present invention are described in the subclaims.

### EFFECTS OF THE INVENTION

In the plasma processing apparatus of the present invention, the cathode, the anode, and the heater are spaced apart from the wall surface of the chamber and supported by the inside structural body, so that there is no need of reinforcement against the atmospheric pressure, leading to simplification of the whole structure of the apparatus and thereby further realizing the lowering of costs.
Also, since the plasma processing apparatus of the present invention is provided with heat-dissipating means for alleviating the temperature rise caused by the Joule heat generated in plasma discharging, the process can be stabilized by stabilizing the temperature during the plasma processing, whereby a good film having a uniform film quality and film thickness can be formed.

Further, the heat conductance to the outside of the apparatus is restrained by the heat-dissipating means, and the cooling apparatus on the outer wall surface of the chamber can be omitted, leading to simplification of the apparatus and thereby further realizing the lowering of costs.
Also, according to the method of producing a semiconductor thin film of the present invention, a semiconductor element using a semiconductor thin film or an optical thin film, such as a solar cell, a TFT, or a photo conductor, can be produced at a lower cost and with a good efficiency.

### BRIEF DESCRIPTION OF THE DRAWINGS

Fig. 1 illustrates an example 1 of a plasma processing apparatus which is useful for the understanding of the invention, where Fig. 1(a) is a schematic cross-sectional view showing a longitudinal structure, and Fig. 1(b) is a schematic plan view showing a planar structure.
Fig. 2 illustrates an example 2 of a plasma processing apparatus which is useful for the understanding of the invention, where Fig. 2(a) is a schematic cross-sectional view showing a longitudinal structure, and Fig. 2(b) is a schematic plan view showing a planar structure.
Fig. 3 is a view in which the heat-dissipating means of example 2 is viewed from the above, where Fig. 3 (a) shows a case in which the protrusion dimension of the wave-shaped fin is changed, Fig. 3(b) shows a case in which the wavelength of the wave-shaped fin is changed, and Fig. 3(c) shows a case in which the protrusion dimension and the wavelength of the wave-shaped fin are changed.
Fig. 4 illustrates the plasma processing apparatus of the present invention, where Fig. 4(a) is a schematic cross-sectional view showing a longitudinal structure of an Embodiment 3-1, and Fig. 4(b) is a schematic cross-sectional view showing a longitudinal structure of an Embodiment 3-2.
Fig. 5 illustrates the air-cooled gas passing pipe in Embodiments 3-1 and 3-2, where Fig. 5(a) is a schematic cross-sectional view showing a structure as viewed from the side-surface side, and Fig. 5(b) is a schematic cross-sectional view showing a structure as viewed from the plane side.
Fig. 6 is a schematic cross-sectional view of a conventional plasma processing apparatus.

### BEST MODES FOR CARRYING OUT THE INVENTION

The plasma processing apparatus of the present invention comprises within a sealable chamber:
an internal structural body that is disposed to be spaced apart from an inner wall surface of the chamber and that forms an inside space for housing a substrate serving as an object of processing;
a substrate holding section that houses the substrate within the inside space;
reactive gas supplying means for supplying a reactive gas to the inside space;
a cathode and an anode that are supported by the internal structural body and disposed on both sides of the substrate within the inside space and that generate plasma discharge of the reactive gas;
a heater that is supported by the internal structural body and that heats the substrate within the inside space; and
heat-dissipating means capable of dissipating a Joule heat generated by the plasma discharge to outside of the inside space, said heat-dissipating means comprising an air-cooled gas passing pipe that is disposed to be in contact with the heater and that absorbs the Joule heat by a coolant gas.

A first characteristic feature of the plasma processing apparatus of the present invention lies in that the cathode, the anode, and the heater are supported by the inside structural body, and the inside structural body is disposed to be spaced apart from the inner wall surface of the chamber.
The inside structural body is not particularly limited as long as it is a structural body having a strength capable of holding the members such as the cathode, the anode, the heater, and others, and not obstructing the exchange of the reactive gas introduced into the inside of the chamber; however, a frame-shaped structural body made of a rectangular member is preferable.
Also, the inside structural body is preferably made of a material having heat conductivity and heat resistance, and is preferably made of stainless steel, aluminum alloy, or the like.

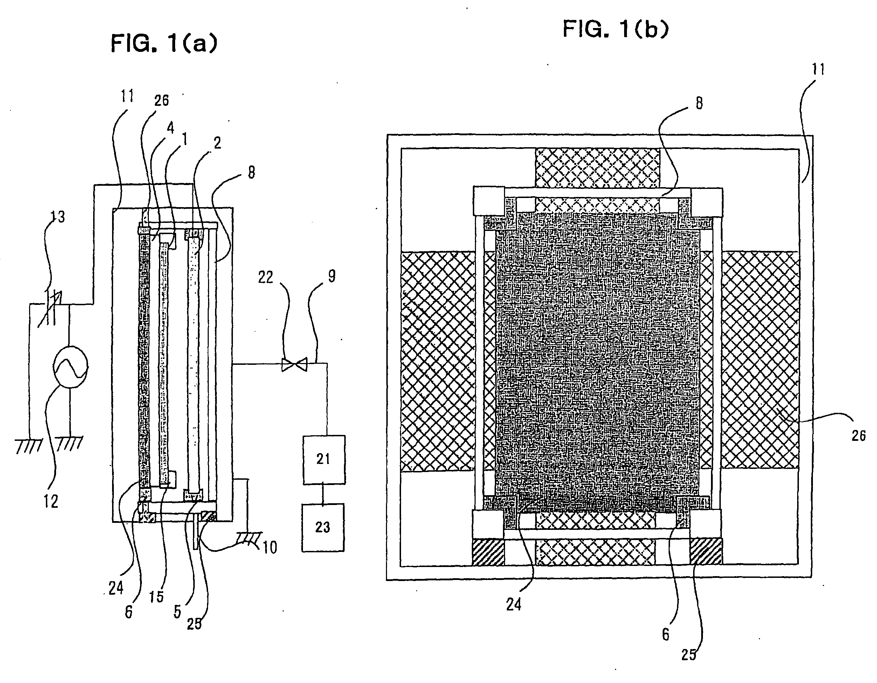

The inside structural body is disposed to be spaced apart from the inner wall surface of the chamber. For example, the inside structural body is preferably disposed in the chamber via a member sufficient to support the weight of the inside structural body.
Such a member may be, for example, a holding leg such as denoted by the symbol 25 of Fig. 1.
The holding leg separates the inside structural body and the chamber from each other and restrains the heat conductance from the inside structural body, so that the length thereof is preferably as long as possible, and the disposing area is preferably as small as possible. The holding leg of Fig. 1 is disposed on the bottom surface of the chamber; however, the position thereof is not particularly limited, so that it may be the side surface or the upper surface of the chamber, or a combination thereof.

A gap of a constant dimension is preferably disposed between the bottom surface of the inside structural body and the lower surface of the anode so as to restrain temperature rise of the inside structural body caused by the radiation heat from the anode.
The dimension of this gap may be suitably determined in accordance with the size of the plasma processing apparatus and other members, and is typically about 10 to 30 mm. Other dimensions of the inside structural body also may be suitably determined in accordance with the size of the plasma processing apparatus and other members.

A second characteristic feature of the plasma processing apparatus of the present invention lies in that the apparatus is provided with heat-dissipating means capable of dissipating a Joule heat generated by plasma discharge to the outside of the inside space.
The heat-dissipating means is not particularly limited as long as it can alleviate temperature rise of the inside space caused by the plasma; however, the heat-dissipating means is preferably
(1) a heat-dissipating plate capable of dissipating the Joule heat to the outside via the chamber by being in contact with the chamber, and/or
(2) a heat-dissipating fin capable of dissipating the Joule heat to the outside of the inside space within the chamber by being in contact with the heater.

Since the apparatus is provided with such heat-dissipating means, the Joule heat generated by plasma discharge is dissipated suitably from the heater to the chamber wall surface by heat conduction. Therefore, even if plasma discharge is carried out under various conditions, the heater temperature is maintained to be constant; the stability of the process is improved; a good film having a uniform film quality and film thickness can be formed; and a continuous operation of the apparatus can be carried out.
Next, each heat-dissipating means will be described.

### (1) Heat-dissipating plate

The heat-dissipating plate is preferably made of a material having heat conductivity and heat resistance, and is particularly preferably made of aluminum, aluminum alloy, copper, iron, nickel, or stainless steel.
The heat-dissipating plate preferably has a shape of a plate, a lattice (a net), or a stripe.
Also, the heat-dissipating plate preferably has a shape that does not obstruct exchange of the reactive gas that is introduced into the inside of the chamber. This increases the conductance of the gas in the plasma discharge region, so that exchange of a large amount of gas can be carried out, and the process is stabilized, hence being preferable.
The heat-dissipating plate is preferably disposed on the outer wall side of the inside structural body on the substrate side to be in contact with the chamber, for example, as shown in Fig. 1.
The heat-dissipating plate preferably dissipates heat having a heat quantity of 418.68 to 4.186,8 J/min. (100 to 1000 cal/min.)

### (2) Heat-dissipating fin

The heat-dissipating fin is an application of a tail-shaped fin that is generally used in a heat exchanger or the like for the purpose of increasing the heat transfer area.
The heat-dissipating fin is preferably made of a material having heat conductivity and heat resistance, and more preferably made of aluminum, aluminum alloy, copper, iron, nickel, or stainless steel.

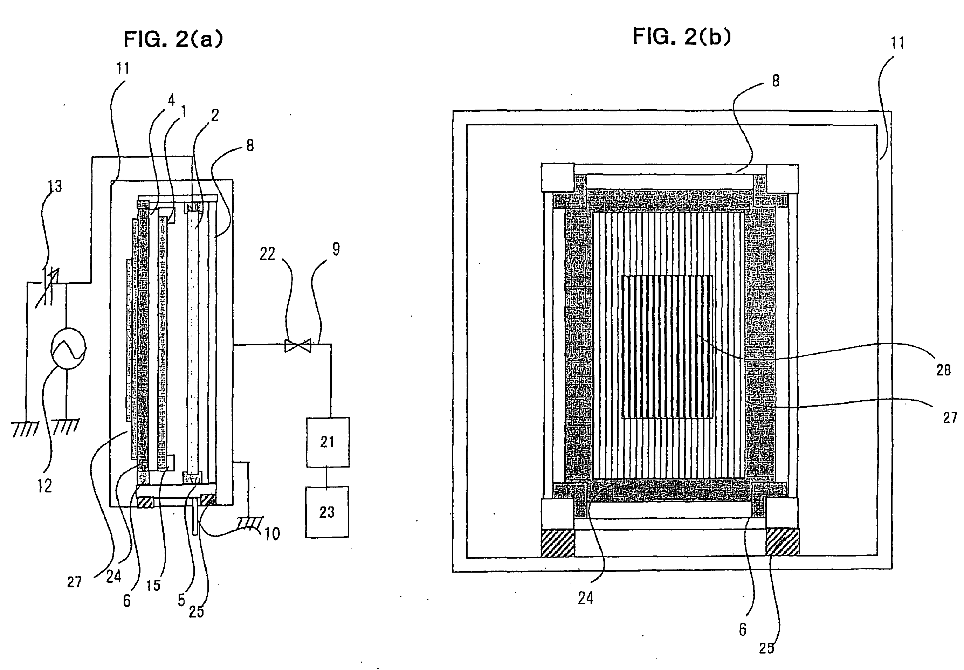

The shape of the heat-dissipating fin is not particularly limited; however, the heat-dissipating fin is preferably constructed to include, for example, a flat plate that is in contact with the back surface of the heater and two kinds of wave-shaped fins that are connected onto the flat plate, where one wave-shaped fin is formed to be dense at the central part of the heater, and the other wave-shaped fin is formed to be sparse at the peripheral part of the heater. Alternatively, the heat-dissipating fin preferably has a construction such that one wave-shaped fin disposed at the central part of the heater is set to have a large protrusion dimension, and the other wave-shaped fin disposed at the peripheral part of the heater is set to have a small protrusion dimension. Namely, it is sufficient to make the surface area of the heat-dissipating fin be large at the central part of the heater and be small at the peripheral part of the heater.
As another structure of the heat-dissipating fin, the densely disposed wave-shaped fin and the sparsely disposed wave-shaped fin described above are constructed with one sheet of metal plate. Further alternatively, the wave-shaped fin may be formed with one sheet of metal plate in a meandering shape as viewed in a plan view, where the wave-shaped fin at the central part is disposed to be dense with a shorter meandering period than that of the wave-shaped fin at the peripheral part.
By suitably adjusting the density, the designed dimension, the shape, and the like of the heat-dissipating fin in this manner, the in-plane distribution of the heater temperature can be adjusted so that the dissipated heat quantity will be large at the central part and small at the peripheral part, for example.
The heat-dissipating fin is preferably disposed on the outer wall of the inside structural body on the substrate side to be in contact with the heater, for example, as shown in Fig. 2.

### (3) Air-cooled gas passing pipe

The air-cooled gas passing pipe is preferably made of a material having heat conductivity and heat resistance, and more preferably made of aluminum, aluminum alloy, copper, iron, nickel, or stainless steel.
The air-cooled gas passing pipe preferably has a structure of discharging an introduced gas directly to the outside of the chamber through the cooling gas introducing pipe.
Also, the air-cooled gas passing pipe may be connected to the reactive gas supplying means and have a structure such that an introduced gas is supplied to the inside space as the reactive gas.

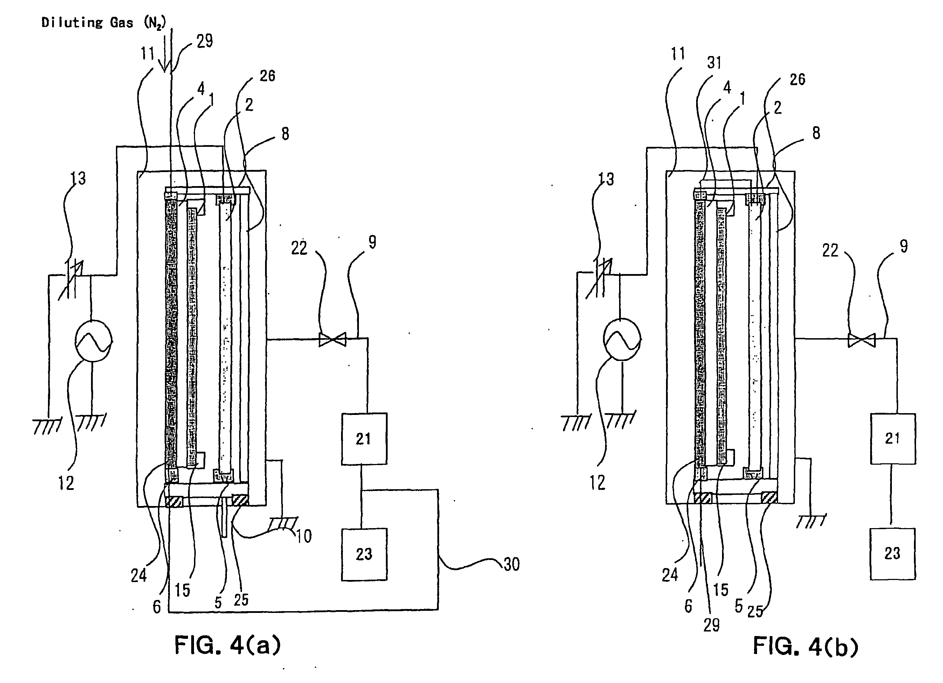

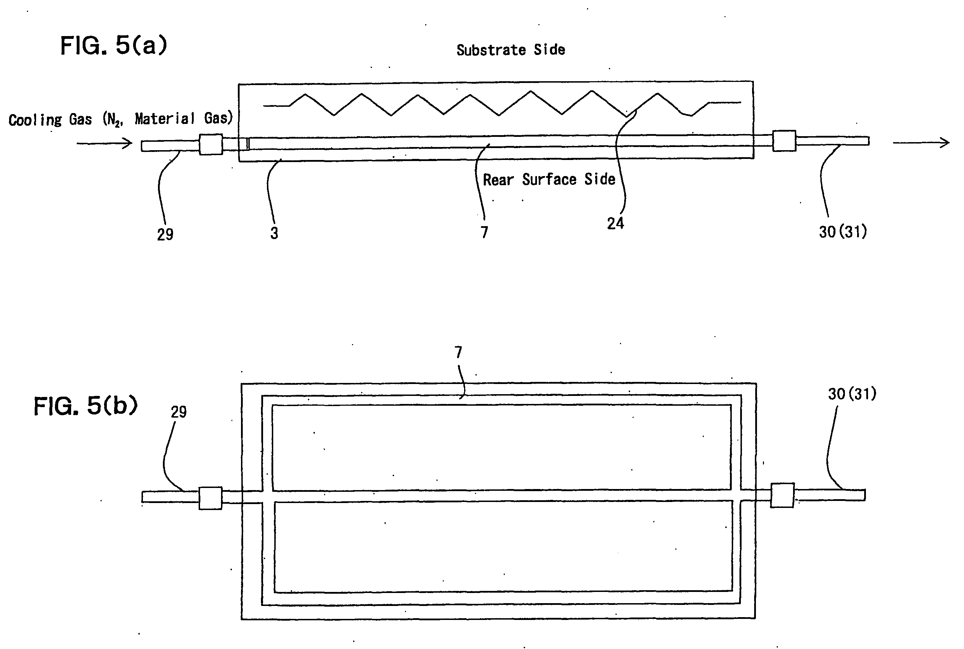

Further, the plasma processing apparatus may include, within a sealable chamber, two or more sets of an internal structural body, reactive gas supplying means, a cathode and an anode, a heater, and heat-dissipating means, wherein the air-cooled gas passing pipe is connected to the reactive gas supplying means of an another set and has a structure such that an introduced gas is supplied to the inside space of the another set as the reactive gas.
The air-cooled gas passing pipe is disposed on the surface of the heater opposing the substrate so as to be in contact with the heater, as shown in Fig. 4, for example. Fig. 4(a) shows an apparatus in which the air-cooled gas passing pipe is not connected to the reactive gas supplying means through the cooling gas introducing pipe, and Fig. 4(b) shows an apparatus in which the above-mentioned connection is established. Also, Fig. 5 shows a structure of an air-cooled gas passing pipe disposed within the heater.

Next, a preferable embodiment of the plasma processing apparatus of the present invention will be described with reference to the drawings. Examples 1 and 2 correspond to the above-described heat-dissipating means (1) and (2) and are useful for the understanding of the present invention, whereas embodiment 3 reflects the present invention.
Here, these embodiments are merely examples, so that implementation in various forms can be made within the scope of the present invention.

### (Example 1)

Fig. 1 is (a) a schematic cross-sectional view showing a longitudinal structure and (b) a schematic plan view showing a planar structure, of the plasma processing apparatus of Example 1.
The chamber 11 is preferably made of a material having a strength as a vacuum vessel and being provided with heat conductivity and heat resistance, and is made of stainless steel, aluminum alloy, or the like.

The chamber 11 is constructed in such a manner that the inside thereof can be controlled to have an arbitrary vacuum degree. For this reason, the engagement part of the chamber 11 is completely sealed with an O-ring or the like. Also, a pressure controller 22 and a vacuum pump 21 are connected to the chamber 11 via a gas exhausting pipe 9, and a removing apparatus 23 for removing harmful substances within the exhaust gas after reaction of the reactive gas introduced into the chamber 11 is connected to the vacuum pump 21.
A holding leg 25 having a sufficient strength capable of supporting the weight of the members such as the inside structural body 8, the cathode 2, the anode 4, and the heater 24 is fixed to the bottom surface of the chamber 11, and the inside structural body 8 is fixed to the holding leg 25.

The inside structural body 8 is a frame-shaped structural body of a rectangular member made of stainless steel, aluminum alloy, or the like and having a sufficient strength capable of supporting the weight of the members such as the cathode 2, the anode 4, and the heater 24.
A gap of a constant dimension is disposed between the bottom surface of the inside structural body 8 and the lower surface of the anode 4 so as to restrain temperature rise of the inside structural body 8 caused by the radiation heat from the anode 4. The dimension of the gap is about 10 to 30 mm in the apparatus of Fig. 1.

The anode 4 is preferably made of a material having heat conductivity and heat resistance, and is more preferably made of stainless steel, aluminum alloy, carbon, or the like.
The dimension of the anode 4 may be suitably set in accordance with the dimension of the substrate 1. In the apparatus of Fig. 1, the dimension of the anode 4 is 1000 to 1500 mm x 600 to 1000 mm while the dimension of the glass substrate 1 is 900 to 1200 x 400 to 900 mm.

The anode 4 incorporates the heater 24.
The heater 24 may be, for example, a heater in which a sealed-type heating apparatus such as a sheath heater and a sealed-type temperature sensor such as a thermocouple are incorporated within an aluminum alloy. By this, the anode 4 can be heated and controlled to room temperature to 300°C, for example.

The part between the heater 24 and the outer wall of the chamber is connected with a heat-dissipating plate 26. Namely, the heat-dissipating plate 26 is disposed on the outer wall side of the inside structural body on the substrate side, and is in contact with the chamber.
The heat-dissipating plate 26 is preferably made of a material having heat conductivity and heat resistance, and is more preferably made of aluminum or aluminum alloy.

The dimension of the heat-dissipating plate 26 may be suitably set in accordance with the dimension of the substrate 1. In the apparatus of Fig. 1, the heat-dissipating plate consists of respective two sheets of aluminum plates having a length of 100 to 500 mm x a width of 1200 to 1000 mm x a thickness of 1 to 3 mm and a length of 100 to 500 mm x a width of 800 to 500 mm x a thickness of 1 to 3 mm.
The heat-dissipating plate 26 preferably has a shape that does not obstruct the exchange of the reactive gas introduced into the inside of the chamber. In the apparatus of Fig. 1, the heat-dissipating plate 26 has a lattice shape (net shape).

Assuming that the heater temperature is 300°C and the outer wall temperature is 60°C with the heat-dissipating plate 26 such as described above, the amount of heat dissipated from this heat-dissipating plate will be about 5.024,16 J/min (1200 cal/min) which is a little larger than the Joule heat generated by plasma discharge.
By this, the Joule heat generated by plasma discharge can be dissipated, so that the temperature during the process can be made constant while maintaining the uniformity within the surface.

The anode 4 is supported by anode supports 6 which are disposed at four corners thereof. The supporting dimension thereof may be suitably set so as not to raise a fear of generating warpage of the anode 4. In the apparatus of Fig. 1, the supporting dimension is 30 mm x 50 mm.
The anode supports 6 are preferably made of a material having a small thermal conductivity so as to restrain the heat rise of the inside structural body 8 by thermal conduction, and zirconia (zirconium oxide) can be employed, for example.

The contact area between the anode 4 and the anode supports 6 is preferably as small as possible in order to restrain transfer of the heat of the anode 4 to the inside structural body 8 by heat conduction of the anode supports 6. In order to make this contact area small, the anode supports 6 may be provided with recesses having a depth of about 1 mm to 5 mm within the range that does not deteriorate the strength of the anode supports 6.

The cathode 2 is preferably made of a material having a heat conductivity and heat resistance, and is more preferably made of stainless steel, aluminum alloy, carbon, or the like.
The dimension of the cathode 2 may be suitably set in accordance with the dimension of the substrate 1. In the apparatus of Fig. 1, the dimension of the anode 4 is 1000 to 1500 mm x 600 to 1000 mm versus the dimension of the glass substrate 1 is 900 to 1200 x 400 to 900 mm.

The cathode 2 has, in the inside thereof, a hollow pipe into which reactive gas is introduced through the reactive gas introducing pipe 10. The reactive gas may be, for example, SiH₄ gas diluted with H₂.
Also, the cathode 2 has, on the surface thereof, numerous through-holes for supplying the reactive gas onto the substrate 1. These through-holes can be formed by a drilling process, and the dimension thereof is, for example, a diameter of about 0.1 to 2 mm and a pitch of about several mm to several cm.

The gap (distance) between the cathode 2 and the anode 4 is about several mm to several ten mm, and the dimension precision is preferably within several %. In the apparatus of Fig. 1, the distance is 2 mm to 30 mm, and the dimension precision is below or equal to 1 %.
The cathode 2 is disposed on the cathode supports 5 so as to oppose the anode 4.
For the cathode supports 5, strength capable of holding the cathode 2 is demanded together with electric insulation property, so that the cathode supports 5 are preferably made of a material, such as ceramics, including zirconia, alumina (aluminum oxide), and glass, for example.

The cathode 2 is supported by the cathode supports 5 that are disposed on the four corners thereof; however, the whole of the peripheries of the cathode 2 may be supported.
In order to restrain transfer of the heat of the cathode 2 to the inside structural body 8 by heat conduction of the cathode supports 5, the contact area between the cathode 2 and the cathode supports 5 is preferably as small as possible within a range that does not generate warpage of the cathode 2. Also, the arrangement thereof may be suitably set in order to satisfy the above-described conditions. In the apparatus of Fig. 1, it is 100 mm x 50 mm.
The cathode supports 5 are mounted on the inside structural body 8 disposed within the chamber 11.

The cathode 2 receives supply of an electric power by being electrically connected to a plasma excitation power source 12 via an impedance matching device 13. For example, the plasma excitation power source 12 has an AC frequency of 1.00 to 108.48 MHz and an output electric power of 10 W to 100 kW. In the apparatus of Fig. 1, the AC frequency is 13.56 to 81.42 MHz, and the output electric power is 10 W to 10 kW.

The substrate 1 may be a substrate for producing a semiconductor element using a semiconductor thin film or an optical thin film, such as a solar cell, a TFT, or a photo conductor. A semiconductor substrate is particularly preferable.
The substrate 1 is disposed by a substrate holding section (holder) 15 that is fixed to the inside structural body 8 on the surface of the anode 4 that opposes the cathode 2.

In the plasma processing apparatus having a construction described above, the gap between the cathode 2 and the anode 4 was filled with a reactive gas at a predetermined flow rate and pressure, and a high-frequency electric power was applied between the cathode 2 and the anode 4, whereby a glow discharge region (plasma discharge region) could be generated between the cathode 2 and the anode 4. Then, an amorphous or crystalline film could be formed on the substrate 1.

### (Example 2)

Fig. 2 is (a) a schematic cross-sectional view showing a longitudinal structure and (b) a schematic plan view showing a planar structure, of the plasma processing apparatus of Example 2.
The structure of the plasma processing apparatus of Example 2 is similar to that of Embodiment 1 except for the structure of the heat-dissipating means, so that mainly the different points will be described. Here, in Fig. 2, constituent elements similar to those of Fig. 1 are denoted with the same symbols.

The anode 4 has a dimension similar to that of Example 1, and incorporates a heater 24.
Also, to the back surface of the heater 24, plural sheets of a heat-dissipating fin 27 are connected. Namely, the heat-dissipating fin 27 is disposed on the outer wall surface of the inside structural body on the substrate side. Here, in Fig. 2, the heat-dissipating fin 27 is not in contact with the chamber 11; however, it may be in contact as well.

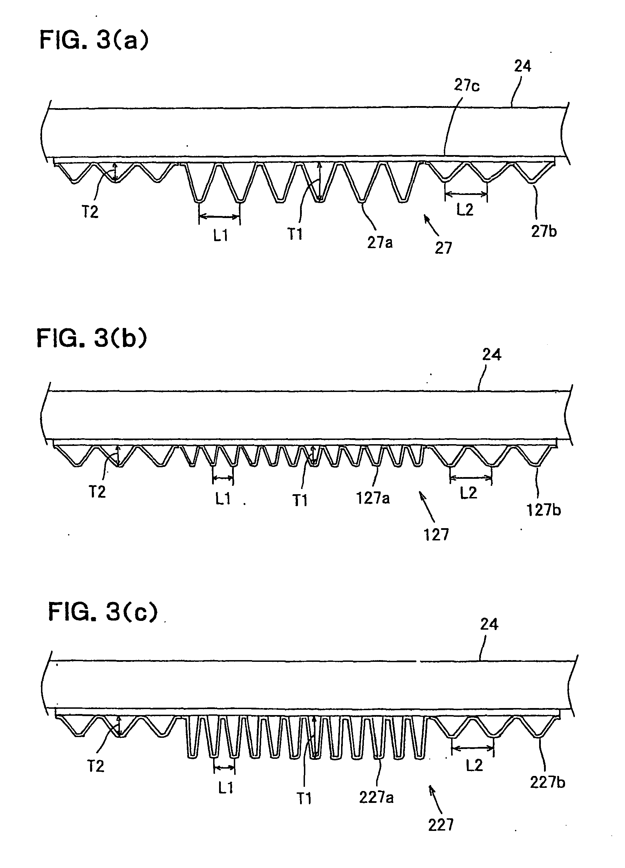

This heat-dissipating fin 27 consists of a flat plate 27c that is in contact with the back surface of the heater 24 and two kinds of wave-shaped fins 27a, 27b that are in contact with and fixed onto the flat plate 27c, as illustrated in Figs. 2(a),(b) and Fig. 3(a). In this heat-dissipating fin 27, on the back surface of the heater, the wave-shaped fin 27a having a large protrusion dimension T1 is disposed at the central part where the Joule heat generated by plasma discharge is liable to be accumulated, and the wave-shaped fin 27b having a small protrusion dimension T2 is disposed at the peripheral part. In this case, the wavelengths (interval) L1, L2 of the waves of the respective wave-shaped fins 27a, 27b are approximately equal. When such a heat-dissipating fin 27 is mounted on the back surface of the heater 24 and the heater temperature is set to be 300°C and the outer wall temperature is set to be 60°C, the amount of heat dissipated from the heat-dissipating fin 27 will be about 5.024,16 J/min (1200 cal/min), which is a little larger than the Joule heat generated by plasma discharge, by designing the heat-dissipating fin 27 as follows.
Material of heat-dissipating fin 27: aluminum
Size of flat plate 27c: longitudinal 1000 to 1500 mm x lateral 600 to 1000mm
Thickness of flat plate 27c: 1 to 10 mm
Thickness of each wave-shaped fin 27a, 27b: 1 to 5 mm
Protrusion dimension T1 of wave-shaped fin 27a: 5 to 30 mm
Protrusion dimension T2 of wave-shaped fin 27b: 3 to 10 mm
Wavelength of each wave-shaped fin 27a, 27b: 5 to 30 mm
Occupied area of wave-shaped fin 27a relative to flat plate 27c: 300000 to 1200000 mm²
Occupied area of wave-shaped fin 27b relative to flat plate 27c: 300000 to 1500000 mm²
By doing so, the Joule heat generated by plasma discharge can be dissipated, so that the temperature during the process can be made constant while maintaining the uniformity within the surface.

Instead of enlarging the surface area by increasing the protrusion dimension T1 of the wave-shaped fin 27a at the central part as shown in Fig. 3(a), the heat-dissipating fin 127 may be constructed so that the wave-shaped fin 127a will be dense at the central part of the heater and the wave-shaped fin 127b will be sparse at the peripheral part of the heater as shown in Fig. 3(b). Namely, in each of the wave-shaped fins 127a, 127b, each of the protrusion dimensions T1, T2 may be made approximately equal, and the wavelength L1 of the wave-shaped fin 127a may be made shorter than the wavelength L2 of the wave-shaped fin 127b. Here, in this case also, various dimensions of each of the wave-shaped fins 127a, 127b are set as described above so that necessary heat dissipation amount can be obtained.
Alternatively, as shown in Fig. 3(c), the heat-dissipating fin 227 may be constructed in such a manner that the protrusion dimension T1 of the wave-shaped fin 227a at the central part is made larger than the protrusion dimension T2 of the wave-shaped fin 227b at the peripheral part, and the wavelength L1 of the wave-shaped fin 227a at the central part may be made shorter than the wavelength L2 of the wave-shaped fin 227b at the peripheral part. Here, in this case also, various dimensions of each of the wave-shaped fins 227a, 227b are set as described above so that necessary heat dissipation amount can be obtained.

In the plasma processing apparatus having a construction described above, the gap between the cathode 2 and the anode 4 was filled with a reactive gas at a predetermined flow rate and pressure, and a high-frequency electric power was applied between the cathode 2 and the anode 4, whereby a glow discharge region (plasma discharge region) could be generated between the cathode 2 and the anode 4. Then, an amorphous or crystalline film could be formed on the substrate 1.

### (Embodiment 3)

Fig. 4(a) is a schematic cross-sectional view showing a longitudinal structure of the plasma processing apparatus of Embodiment 3-1, and Fig. 4(b) is a schematic cross-sectional view showing a longitudinal structure of the plasma processing apparatus of Embodiment 3-2.
Also, Fig. 5 is a schematic view showing a structure of an air-cooled gas passing pipe 7 disposed in the heater in the plasma processing apparatus of Embodiment 3, where Fig. 5(a) is a view as viewed from the side-surface side, and Fig. 5(b) is a view as viewed from the plane side.
The structure of the plasma processing apparatus of Embodiment 3 is similar to that of example 1 except for the structure of the heat-dissipating means, so that mainly the different points will be described. Here, in Figs. 4 and 5, constituent elements similar to those of Fig. 1 are denoted with the same symbols.

The anode 4 incorporates a heater 24 with a dimension similar to that of example 1. For example, as shown in Fig. 5, the anode 4 is integrated with the heater 24 and the air-cooled gas passing pipe 7. Namely, the air-cooled gas passing pipe 7 is incorporated in the surface of the heater 24 that opposes the substrate 1.

Fig. 5(b) exemplifies a case in which the air-cooled gas passing pipe 7 is branched into three pipes from the cooling gas introducing pipe 29, extends in parallel in the longitudinal direction of the heater 24, and converges into one pipe again to be connected to the coolant gas exhausting pipe 30. This air-cooled gas passing pipe 7 may be designed in such a manner that, instead of being limited to the mode of Fig. 5(b), the gas pipe is formed, for example, in a meandering shape to be dense at the central part so that the Joule heat generated by plasma discharge may be easily absorbed. For example, when hydrogen constituting a part of the material gas is introduced into the air-cooled gas passing pipe 7 that is made of aluminum having a good heat conductivity and is installed in this manner, the amount of heat dissipated from the air-cooled gas passing pipe 7 will be about 4.186,8 to 12.560,4 J/min (1000 to 3000 cal/min) which is a little larger than the Joule heat generated by plasma discharge.
By this, the Joule heat generated by plasma discharge can be dissipated, so that the temperature during the process can be made constant while maintaining the uniformity within the surface.

In the apparatus of Embodiment 3-1, the cooling gas is introduced into the air-cooled gas passing pipe 7 through the cooling gas introducing pipe 29, and is exhausted through the cooling gas exhausting pipe 30, as shown in Fig. 4(a).
On the other hand, in the apparatus of Embodiment 3-2, instead of the cooling gas, the reactive gas (source material gas) is introduced into the air-cooled gas passing pipe 7 through the cooling gas introducing pipe 29, and this is passed, without being exhausted, through the coolant gas exhausting pipe 31 and supplied to the inside space through the cathode 2 as the reactive gas, as shown in Fig. 4(b). Generally, heating the source material gas to a suitable extent leads to higher product quality of the film or improvement in the cleaning rate, so that the gas heating by which the source material gas is passed through the air-cooled gas passing pipe 7 to absorb the Joule heat gives a good influence on the process, hence preferable.
Therefore, the air-cooled gas passing pipe preferably has a structure of being connected to the reactive gas supplying means, whereby the introduced gas is supplied to the inside space as the reactive gas.

In Embodiment 3-1, inert gas such as nitrogen is used as the cooling gas. However, since the thermal conductivity of nitrogen is about 1/8 as compared with hydrogen, the gas must be introduced at a flow rate that is higher by about one digit in order to carry out heat dissipation equivalent to that of the case of Embodiment 3-2.
Therefore, it is preferable to use in common the exhaust gas diluting nitrogen used as a diluent gas of hydrogen that typically used as a part of the source material gas. By this, the heat dissipation amount by the gas will be about 4.186,8 to 12.560,4 J/min (1000 to 3000 cal/min), and the temperature of the exhausted nitrogen gas can be raised by several ten °C, whereby the clogging of the exhaust gas pipe accompanying the adhesion of powder can be prevented owing to the temperature maintaining effect of the exhaust gas pipe, hence preferable.

As a modification of Embodiment 3-2, the plasma processing apparatus of the present invention may include, within a sealable chamber, two or more sets of an internal structural body, reactive gas supplying means, a cathode and an anode, a heater, and heat-dissipating means, wherein the air-cooled gas passing pipe is connected to the reactive gas supplying means of an another set and has a structure such that an introduced gas is supplied to the inside space of the another set as the reactive gas. Namely, by constructing in such a manner that a coolant gas exhausting pipe connected to one heater is branched into plural pipes to be connected to plural reactive gas supplying means (gas introducing pipes), the air-cooled gas passing pipe within one heater is connected to plural cathode insides. By this, the reactive gas heated in one heater can be supplied to plural inside spaces.

In the plasma processing apparatus having a construction described above, the gap between the cathode 2 and the anode 4 was filled with a reactive gas at a predetermined flow rate and pressure, and a high-frequency electric power was applied between the cathode 2 and the anode 4, whereby a glow discharge region (plasma discharge region) could be generated between the cathode 2 and the anode 4. Then, an amorphous or crystalline film could be formed on the substrate 1.

In this manner, according to the present invention, there is provided a method of producing a semiconductor thin film characterized by producing a semiconductor thin film on a surface of a substrate by using the plasma processing apparatus described above.
Also, according to the method of producing a semiconductor thin film of the present invention, a semiconductor element using a semiconductor thin film or an optical thin film, such as a solar cell, a TFT, or a photo conductor, can be produced at a lower cost and with a good efficiency.

## Claims

1. A plasma processing apparatus comprising within a sealable chamber (11):
an internal structural body (8) that is disposed to be spaced apart from an inner wall surface of the chamber (11) and that forms an inside space for housing a substrate (1) serving as an object of processing;
a substrate holding section (15) that is adapted to house the substrate (1) within the inside space;
reactive gas supplying means (10) for supplying a reactive gas to the inside space;
a cathode (2) and an anode (4) that are supported by the internal structural body (8) and disposed on both sides of the substrate (1) within the inside space and that are adapted to generate in use a plasma discharge of the reactive gas; and
a heater (24) that is supported by the internal structural body (8) and that is adapted to heat the substrate (1) within the inside space;
**characterized by**
an air-cooled gas passing pipe (7) that is disposed to be in contact with the heater (24) and that is adapted to absorb a Joule heat by a coolant gas, the Joule heat being generated in use by the plasma discharge between the cathode (2) and the anode (4).

2. The plasma processing apparatus according to claim 1, further comprising a heat-dissipating plate (26) capable of dissipating the Joule heat to the outside via the chamber (11) by being in contact with the heater and an outer wall of the chamber.

3. The plasma processing apparatus according to claim 1, further comprising a heat-dissipating fin (27) capable of dissipating the Joule heat to the outside of the inside space within the chamber (11) by being in contact with the heater (24).

4. The plasma processing apparatus according to claim 2, wherein the heat-dissipating plate (26) is made of aluminum, aluminum alloy, copper, iron, nickel, or stainless steel.

5. The plasma processing apparatus according to claim 2, wherein the heat-dissipating plate (26) has a shape of a plate, a lattice, or a stripe.

6. The plasma processing apparatus according to claim 2, wherein the heat-dissipating plate (26) is disposed on an outer wall side of the internal structural body (8).

7. The plasma processing apparatus according to claim 3, wherein the heat-dissipating fin (27) is made of aluminum, aluminum alloy, copper, iron, nickel, or stainless steel.

8. The plasma processing apparatus according to claim 3, wherein the heat-dissipating fin (27) is disposed to be dense at a central part of the heater (24) and to be sparse at a peripheral part of the heater (24).

9. The plasma processing apparatus according to claim 3, wherein the heat-dissipating fin (27) has a protrusion dimension being large at a central part of the heater (24) and being small at a peripheral part of the heater (24).

10. The plasma processing apparatus according to claim 3, wherein the heat-dissipating fin (27) consists of a flat plate that is in surface-contact with the heater (24) and a wave-shaped fin that is connected onto this flat plate.

11. The plasma processing apparatus according to claim 1, wherein the air-cooled gas passing pipe (7) has a structure of discharging an introduced gas directly to the outside of the chamber (11).

12. The plasma processing apparatus according to claim 1, wherein the air-cooled gas passing pipe (7) is connected to the reactive gas supplying means and has a structure such that a introduced gas is supplied to the inside space as the reactive gas.

13. The plasma processing apparatus according to claim 1, wherein the air-cooled gas passing pipe (7) is made of aluminum, aluminum alloy, copper, iron, nickel, or stainless steel.

14. The plasma processing apparatus according to claim 1, comprising, within the sealable chamber (11), two or more sets of an internal structural body (8), reactive gas supplying means (10), cathode (2) and anode (4), heater (24), and heat-dissipating means (26, 27), wherein the air-cooled gas passing pipe is connected to the reactive gas supplying means of an another set of and has a structure such that an introduced gas is supplied to the inside space of the another set as the reactive gas.

15. A method of producing a semiconductor thin film **characterized by** producing a semiconductor thin film on a surface of a substrate by using the plasma processing apparatus according to claim 1.

## Patentansprüche

1. Plasmabearbeitungsvorrichtung, die in einer abdichtbaren Kammer (11) enthält:
einen inneren Strukturkörper (8), der so angeordnet ist, dass er von einer Innenwandoberfläche der Kammer (11) beabstandet ist, und einen Innenraum bildet, um ein Substrat (1), das als ein Bearbeitungsgegenstand dient, aufzunehmen;
einen Substrathalteabschnitt (15), der dazu ausgelegt ist, das Substrat (1) in dem Innenraum aufzunehmen;
Mittel (10) zum Zuführen eines reaktiven Gases, um dem Innenraum ein reaktives Gas zuzuführen;
eine Katode (2) und eine Anode (4), die durch den inneren Strukturkörper (8) unterstützt sind und an beiden Seiten des Substrats (1) innerhalb des Innenraums angeordnet sind und dazu ausgelegt sind, im Betrieb eine Plasmaentladung des reaktiven Gases zu erzeugen; und
eine Heizeinrichtung (24), die durch den inneren Strukturkörper (8) unterstützt ist und dazu ausgelegt ist, das Substrat (1) innerhalb des Innenraums zu erhitzen;
**gekennzeichnet durch**
ein luftgekühltes Gasdurchlassrohr (7), das so angeordnet ist, dass es mit der Heizeinrichtung (24) in Kontakt ist, und das dazu ausgelegt ist, Joulesche Wärme **durch** ein Kühlgas zu absorbieren, wobei die Joulesche Wärme im Betrieb **durch** die Plasmaentladung zwischen der Katode (2) und der Anode (4) erzeugt wird.

2. Plasmabearbeitungsvorrichtung nach Anspruch 1, die ferner eine Wärmeabführungsplatte (26) enthält, die die Joulesche Wärme durch die Kammer (11) nach außen abführen kann, indem sie mit der Heizeinrichtung und mit der Außenwand der Kammer in Kontakt ist.

3. Plasmabearbeitungsvorrichtung nach Anspruch 1, die ferner eine Wärmeabführungsrippe (27) enthält, die die Joulesche Wärme in die äußere Umgebung des Innenraums innerhalb der Kammer (11) abführen kann, indem sie mit der Heizeinrichtung (24) in Kontakt ist.

4. Plasmabearbeitungsvorrichtung nach Anspruch 2, wobei die Wärmeabführungsplatte (26) aus Aluminium, einer Aluminiumlegierung, Kupfer, Eisen, Nickel oder Edelstahl hergestellt ist.

5. Plasmabearbeitungsvorrichtung nach Anspruch 2, wobei die Wärmeabführungsplatte (26) die Form einer Platte, eines Gitters oder eines Streifens hat.

6. Plasmabearbeitungsvorrichtung nach Anspruch 2, wobei die Wärmeabführungsplatte (26) an einer Außenwandseite des inneren Strukturkörpers (8) angeordnet ist.

7. Plasmabearbeitungsvorrichtung nach Anspruch 3, wobei die Wärmeabführungsrippe (26) aus Aluminium, einer Aluminiumlegierung, Kupfer, Eisen, Nickel oder Edelstahl hergestellt ist.

8. Plasmabearbeitungsvorrichtung nach Anspruch 3, wobei die Wärmeabführungsrippe (27) so angeordnet ist, dass sie in einem Mittelteil der Heizeinrichtung (24) dick ist und an einem Umfangsteil der Heizeinrichtung (24) dünn ist.

9. Plasmabearbeitungsvorrichtung nach Anspruch 3, wobei die Wärmeabführungsrippe (27) eine vorspringende Abmessung hat, die in einem Mittelteil der Heizeinrichtung (24) groß ist und in einem Umfangsteil der Heizeinrichtung (24) klein ist.

10. Plasmabearbeitungsvorrichtung nach Anspruch 3, wobei die Wärmeabführungsrippe (27) aus einer ebenen Platte besteht, die mit der Heizeinrichtung (24) in einem Oberflächenkontakt ist, und aus einer wellenförmigen Rippe besteht, die auf dieser ebenen Platte mit dieser verbunden ist.

11. Plasmabearbeitungsvorrichtung nach Anspruch 1, wobei das luftgekühlte Gasdurchlassrohr (7) eine Struktur zum direkten Ausgeben eines eingeleiteten Gases in die äußere Umgebung der Kammer (11) besitzt.

12. Plasmabearbeitungsvorrichtung nach Anspruch 1, wobei das luftgekühlte Gasdurchlassrohr (7) mit den Mitteln zum Zuführen eines reaktiven Gases verbunden ist und eine Struktur besitzt, derart, dass ein eingeleitetes Gas dem Innenraum als das reaktive Gas zugeführt wird.

13. Plasmabearbeitungsvorrichtung nach Anspruch 1, wobei das luftgekühlte Gasdurchlassrohr (7) aus Aluminium, einer Aluminiumlegierung, Kupfer, Eisen, Nickel oder Edelstahl hergestellt ist.

14. Plasmabearbeitungsvorrichtung nach Anspruch 1, die in der abdichtbaren Kammer (11) zwei oder mehr Gruppen aus einem inneren Strukturkörper (8), Mitteln (10) zum Zuführen eines reaktiven Gases, Katode (2) und Anode (4), Heizeinrichtung (24) und Wärmeabführungsmitteln (26, 27) enthält, wobei das luftgekühlte Gasdurchlassrohr mit den Mitteln zum Zuführen eines reaktiven Gases einer weiteren Gruppe verbunden ist und eine Struktur besitzt, derart, dass ein eingeleitetes Gas dem Innenraum der weiteren Gruppe als das reaktive Gas zugeführt wird.

15. Verfahren zum Herstellen einer Halbleiterdünnschicht, **gekennzeichnet durch** das Herstellen einer Halbleiterdünnschicht auf einer Oberfläche eines Substrats unter Verwendung der Plasmabearbeitungsvorrichtung nach Anspruch 1.

## Revendications

1. Appareil de traitement au plasma comprenant à l'intérieur d'une chambre scellable (11) :
un corps structurel interne (8) qui est disposé de manière à être espacé d'une surface de paroi intérieure de la chambre (11) et qui forme un espace intérieur destiné à recevoir un substrat (1) servant d'objet de traitement ;
une partie de maintien de substrat (15) qui est adaptée pour recevoir le substrat (1) dans l'espace intérieur ;
des moyens d'alimentation en gaz réactif (10) pour délivrer un gaz réactif à l'espace intérieur ;
une cathode (2) et une anode (4) qui sont supportées par le corps structurel interne (8) et disposées des deux côtés du substrat (1) dans l'espace intérieur et qui sont adaptées pour générer, en utilisation, une décharge de plasma du gaz réactif ; et
un élément de chauffage (24) qui est supporté par le corps structurel interne (8) et qui est adapté pour chauffer le substrat (1) dans l'espace intérieur ;
**caractérisé par**
un tuyau de passage de gaz refroidi par de l'air (7) qui est disposé de manière à être en contact avec l'élément de chauffage (24) et qui est adapté pour absorber de la chaleur générée par effet Joule par un gaz de refroidissement, la chaleur étant générée par effet Joule, en utilisation, par la décharge de plasma entre la cathode (2) et l'anode (4).

2. Appareil de traitement au plasma selon la revendication 1, comprenant en outre une plaque de dissipation de chaleur (26) apte à dissiper la chaleur générée par effet Joule vers l'extérieur via la chambre (11) en étant en contact avec l'élément de chauffage et une paroi extérieure de la chambre.

3. Appareil de traitement au plasma selon la revendication 1, comprenant également une ailette de dissipation de chaleur (27) apte à dissiper la chaleur générée par effet Joule vers l'extérieur de l'espace intérieur dans la chambre (11) en étant en contact avec l'élément de chauffage (24).

4. Appareil de traitement au plasma selon la revendication 2, dans lequel la plaque de dissipation de chaleur (26) est en aluminium, alliage d'aluminium, cuivre, fer, nickel ou acier inoxydable.

5. Appareil de traitement au plasma selon la revendication 2, dans lequel la plaque de dissipation de chaleur (26) présente une forme de plaque, de treillis ou de bande.

6. Appareil de traitement au plasma selon la revendication 2, dans lequel la plaque de dissipation de chaleur (26) est disposée sur un côté de paroi extérieur du corps structurel interne (8).

7. Appareil de traitement au plasma selon la revendication 3, dans lequel l'ailette de dissipation de chaleur (27) est en aluminium, alliage d'aluminium, cuivre, fer, nickel ou acier inoxydable.

8. Appareil de traitement au plasma selon la revendication 3, dans lequel l'ailette de dissipation de chaleur (27) est disposée de manière à être dense sur une partie centrale de l'élément de chauffage (24) et à être éparse sur une partie périphérique de l'élément de chauffage (24).

9. Appareil de traitement au plasma selon la revendication 3, dans lequel l'ailette de dissipation de chaleur (27) présente une dimension de saillie plus grande sur une partie centrale de l'élément de chauffage (24) et plus petite sur une partie périphérique de l'élément de chauffage (24).

10. Appareil de traitement au plasma selon la revendication 3, dans lequel l'ailette de dissipation de chaleur (27) est constituée d'une plaque plate dont la surface est en contact avec l'élément de chauffage (24) et une ailette de forme ondulée qui est reliée à cette plaque plate.

11. Appareil de traitement au plasma selon la revendication 1, dans lequel le tuyau de passage de gaz refroidi par de l'air (7) présente une structure de décharge d'un gaz introduit directement vers l'extérieur de la chambre (11).

12. Appareil de traitement au plasma selon la revendication 1, dans lequel le tuyau de passage de gaz refroidi par de l'air (7) est relié aux moyens d'alimentation en gaz réactif et présente une structure telle qu'un gaz introduit est délivré à l'espace intérieur en tant que gaz réactif.

13. Appareil de traitement au plasma selon la revendication 1, dans lequel le tuyau de passage de gaz refroidi par de l'air (7) est en aluminium, alliage d'aluminium, cuivre, fer, nickel ou acier inoxydable.

14. Appareil de traitement au plasma selon la revendication 1, comprenant, à l'intérieur de la chambre scellable (11), deux ou plus de deux ensembles d'un corps structurel interne (8), de moyens d'alimentation en gaz réactif (10), d'une cathode (2) et d'une anode (4), d'un élément de chauffage (24) et de moyens de dissipation de chaleur (26, 27), dans lequel le tuyau de passage de gaz refroidi par de l'air est relié aux moyens d'alimentation en gaz réactif d'un autre ensemble et présente une structure telle qu'un gaz introduit est délivré à l'espace intérieur d'un autre ensemble en tant que gaz réactif.

15. Procédé de production d'un film mince semi-conducteur, **caractérisé par** la production d'un film mince semi-conducteur sur une surface d'un substrat en utilisant l'appareil de traitement au plasma selon la revendication 1.
